# EUROPEAN PATENT APPLICATION

(11) **EP 4 579 742 A1**
(43) Date of publication of application: **02.07.2025**
(21) Application number: 24195007.0
(22) Date of filing: 16.08.2024
(51) Int. Cl.: H01L 23/58, H01L 23/10, H01L 21/60

(54) **LIDDED ELECTRONIC PACKAGE CONTAINING A BATTERY**

(30) Priority: 28.12.2023 CN 202311839389
(71) Applicant: NXP USA, Inc., Austin, TX 78735 (US)
(72) Inventor: Shah, Ankur Shailesh, 5656AG Eindhoven (NL); Vincent, Michael B, 5656AG Eindhoven (NL); Ge, You, 5656AG Eindhoven (NL)
(74) Representative: Hardingham, Christopher Mark

(57) **Abstract**

An electronic package (100) with a battery (102) and method for producing the electronic package uses a domed lid (104) that is attached to a substrate (108) with an electronic component, such as a die (106). The battery (102) is attached to an inner surface of the domed lid and electrically connected to the electronic component via the domed lid.

## Description

### FIELD OF THE INVENTION

The invention relates generally to packaging of electronic components. In particular, the invention relates to an electronic package with a battery.

### BACKGROUND

Some electronic components are packaged with batteries to provide power to the integrated circuitry contained in the electronic components. In some packages, molded battery holders are used to secure the batteries onto the underlying structures, which may include dies and other electronic components.

### SUMMARY

An electronic package with a battery and method for producing the electronic package uses a domed lid that is attached to a substrate with an electronic component, such as a die. The battery is attached to an inner surface of the domed lid and electrically connected to the electronic component via the domed lid.

In an embodiment, an electronic package comprises a substrate, an electronic component attached to the substrate, a domed lid attached to the substrate such that the electronic component is enclosed by the domed lid, and a battery attached to an inner surface of the domed lid and electrically connected to the electronic component via the domed lid.

In an embodiment, the battery includes positive and negative sides and at least one of the positive and negative sides of the battery is electrically connected to an electrical trace on the inner surface of the domed lid that is electrically connected to the electronic component via the substrate.

In an embodiment, the electronic component is a die physically attached to the substrate and electrically attached to the substrate via bondwires and positive and negative sides of the battery are electrically connected to conductive traces on the inner surface of the domed lid that are electrically connected to the die via the substrate and the bondwires.

In an embodiment, the electronic package further comprises epoxy that covers the bondwires.

In an embodiment, the electronic component is a die attached to the substrate and at least one of positive and negative sides of the battery is electrically connected to an electrical trace on the inner surface of the domed lid that is electrically connected to the die via the substrate.

In an embodiment, one of the positive and negative sides of the battery is physically attached to the die using an electrically conductive adhesive material such that the die is sandwiched between the battery and the substrate.

In an embodiment, the electrically conductive adhesive material is electrically connected to at least one electrically conductive via in the die to electrically connect the battery to the substrate.

In an embodiment, the electrically conductive adhesive material extends to a side of the die and onto the substrate to electrically connect the battery to the substrate.

In an embodiment, the domed lid is a pre-molded electrically insulating structure.

In an embodiment, the domed lid is attached to the substrate using an electrically conductive adhesive material that provides electrical connection between the domed lid and the substrate.

In an embodiment, the domed lid includes an electrical trace on the inner surface of the domed lid that is electrically connected to the battery and the electrically conductive adhesive material.

In an embodiment, the electronic component is a die, a multi-die component, a stacked die or a surface mounted device (SMD) component.

In an embodiment, a method for producing an electronic package comprises providing a substrate with an electronic component attached to the substrate, mounting a battery to an inner surface of a domed lid, and attaching the domed lid to the substrate such that the electronic component is enclosed by the domed lid along with the battery and the battery is electrically connected to the electronic component via the domed lid.

In an embodiment, the battery includes positive and negative sides and mounting the battery includes electrically connecting at least one of the positive and negative sides of the battery to an electrical trace on the inner surface of the domed lid so that the battery is electrically connected to the electronic component via the substrate when the domed lid is attached to the substrate.

In an embodiment, the electronic component is a die physically attached to the substrate and electrically attached to the substrate via bondwires and mounting the battery includes electrically connecting positive and negative sides of the battery to conductive traces on the inner surface of the domed lid so that the positive and negative sides of the battery are electrically connected to the die via the substrate and the bondwires when the domed lid is attached to the substrate.

In an embodiment, the electronic component is a die attached to the substrate and mounting the battery includes electrically connecting at least one of positive and negative sides of the battery to an electrical trace on the inner surface of the domed lid so that the battery is electrically connected to the die via the substrate when the domed lid is attached to the substrate.

In an embodiment, attaching the domed lid to the substrate includes physically attaching one of the positive and negative sides of the battery to the die using an electrically conductive adhesive material such that the die is sandwiched between the battery and the substrate.

In an embodiment, physically attaching one of the positive and negative sides of the battery to the die includes electrically connecting the electrically conductive adhesive material to at least one electrically conductive via in the die to electrically connect the battery to the substrate.

In an embodiment, physically attaching one of the positive and negative sides of the battery to the die includes extending the electrically conductive adhesive material to a side of the die and onto the substrate to electrically connect the battery to the substrate.

In an embodiment, an electronic package comprises a substrate, a die attached to the substrate, a domed lid with a conductive trace attached to the substrate such that the die is enclosed by the domed lid and the conductive trace is electrically connected to the substrate, and a battery attached to an inner surface of the domed lid and electrically connected to the conductive trace of the domed lid.

Other aspects in accordance with the invention will become apparent from the following detailed description, taken in conjunction with the accompanying drawings, illustrated by way of example of the principles of the invention.

### BRIEF DESCRIPTION OF THE DRAWINGS

Fig. 1 depicts an integrated lidded electronic package with a battery in accordance with a first embodiment of the invention.
Figs. 2A-2H illustrate a process of producing the integrated lidded electronic package of Fig. 1 in batches in accordance with an embodiment of the invention.
Fig. 3A depicts an integrated lidded electronic package with a battery in accordance with a second embodiment of the invention.
Fig. 3B depicts an integrated lidded electronic package with a battery in accordance with an alternative embodiment of the invention.
Figs. 4A-4G illustrate a process of producing the integrated lidded electronic package of Fig. 3A in batches in accordance with an embodiment of the invention.
Fig. 5 shows a flow diagram of a method for producing an electronic package, such as the integrated lidded electronic packages depicted in Figs. 1, 3A and 3B, in accordance with an embodiment of the invention.

Throughout the description, similar reference numbers may be used to identify similar elements.

### DETAILED DESCRIPTION

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment", "an embodiment", or similar language means that a particular feature, structure, or characteristic described in connection with the indicated embodiment is included in at least one embodiment of the present invention. Thus, the phrases "in one embodiment", "in an embodiment", and similar language throughout this specification may, but do not necessarily, all refer to the same embodiment.

A concern with the molded battery holders used in conventional electronic packages is that the battery holders may cause the batteries to experience high temperatures, which may significantly degrade the performance of the batteries. In addition, the batteries can expand and swell or contract depending on the ambient temperature over time, which can damage the molded battery holders and other components in the packages. Furthermore, the batteries are typically mounted on printed circuit boards next to packaged components, which can increase overall size and cost of the packages. Lastly, conventional packages with batteries may have limitations with respect to the number of components that can be packaged together.

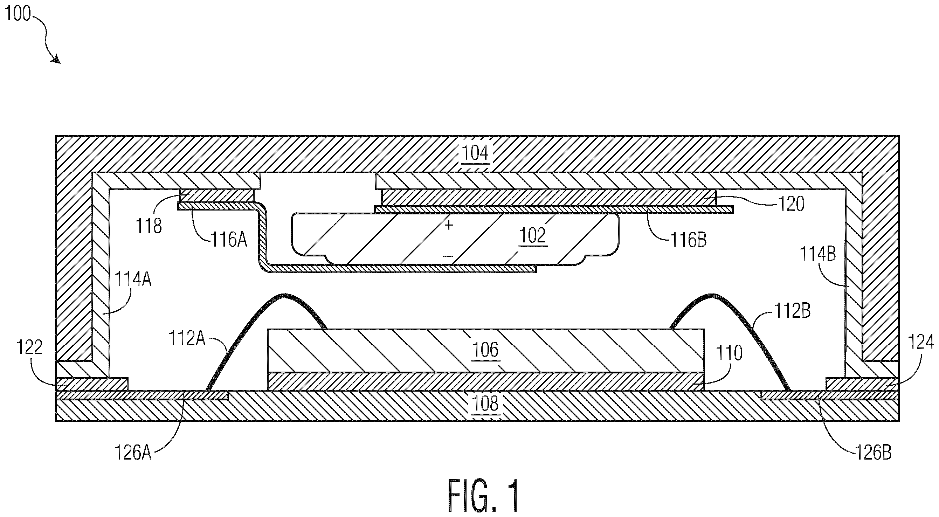

Accordingly, embodiments described herein can have advantages over previous approaches used in electronic packages with batteries. Fig. 1 depicts an integrated lidded electronic package 100 with a battery 102 in accordance with a first embodiment of the invention that addresses at least some of the concerns described above with respect to conventional electronic packages with molded battery holders. As shown in Fig. 1, the integrated lidded electronic package 100 uses a domed lid 104 to enclose the battery 102 and at least one die 106 in a compact form factor. Unlike some conventional electronic packages with batteries, the integrated lidded electronic package 100 does not use a molded battery holder, which may not be able to handle potential high temperatures generated by the battery 102, as well as any expansion/contraction in battery size over time. In addition, the battery 102 in the integrated lidded electronic package 100 is not laterally positioned next to the die 106, as in some conventional electronic packages, which decreases the overall size of the package with respect to volume, footprint or both.

As shown in Fig. 1, the integrated lidded electronic package 100 includes a substrate 108 on which the die 106 is attached. The substrate may be a printed circuit board or any appropriate substrate with electrical traces or connections. The die 106 can be any type of die with integrated circuits fabricated on or within semiconductor material. The die is physically attached to the substrate, for example, using a bonding material 110, such as epoxy, eutectic material or solder, as nonlimiting examples. In other embodiments, the die may be directly bonded to the substrate using, for example, a welding process. The die is also electrically connected to the substrate. In this embodiment, bondwires are used to electrically connect the die to the substrate. At least two of these bondwires, e.g., bondwires 112A and 112B, are used to electrically connect the die to the positive and negative sides of the battery 102, as described below. The wires can be left exposed or covered with epoxy to protect the wires. This can be achieved by dispensing epoxy over the bondwires and fully or partially over the die 106. In other embodiments, the integrated lidded electronic package 100 may include more than one die, e.g., stacked die or multi-die component, and other electronic components, e.g., surface mount device (SMD) components, attached to the substrate 108.

The domed lid 104 is physically attached to the substrate 108 to enclose the die 106, as well as the battery 102. The domed lid may be made of any plastic material, such as liquid crystal polymer (LCP), ceramic or other suitable electrically non-conductive or electrically insulating material. In one or more embodiments, the domed lid is a pre-molded polymer structure. The domed lid includes electrical traces 114A and 114B on the inner surface of the domed lid, i.e., the surface facing the die 106. In one or more embodiments, the electrical traces 114A and 114B are patterned plating or coating, which can be created by sputtering a conductive material, e.g., copper, onto the inner surface of the domed lid or by using other suitable process. The patterning of the plating to create electrical isolation between the electrical traces 114A and 114B can be achieved by "selectively" etching the plating.

The battery 102 is attached to the domed lid 104 via leads 116A and 116B, which provide electrical contacts for the battery. These leads may be pins, clips or tabs that provide electrical connection to positive and negative terminals of the battery and secure the battery in place. In the illustrated embodiment, the battery 102 is a coin-type battery with a positive side and a negative side. However, the battery can be any type of battery, such as a button-type battery as one nonlimiting example. The lead 116A, which contacts the negative side of the battery 102 in the illustrated embodiment, is attached to the electrical trace 114A on the domed lid 104 using an electrically conductive adhesive material 118, such as a low temperature cure electrically conductive adhesive (ECA). Similarly, the lead 116B, which contacts the positive side of the battery 102 in the illustrated embodiment, is attached to the electrical trace 114B on the domed lid 104 using an electrically conductive adhesive material 120, which may be the same material as the electrically conductive adhesive material 118. The domed lid 104 is also physically attached to the substrate using electrically conductive adhesive materials 122 and 124, such as an ECA. Thus, the negative side of the battery 102 is electrically connected to the die 106 through the lead 116A, the electrical trace 114A, an electrical trace 126A on or within the substrate 108 and the bondwire 112A. Similarly, the positive side of the battery 102 is electrically connected to the die 106 through the lead 116B, the electrical trace 114B, an electrical trace 126B on or within the substrate 108 and the bondwire 112B. In other embodiments, the battery 102 may be rotated so that the negative side of the battery is attached to the domed lid 104 and the positive side of the battery is attached to the substrate 108.

In one or more alternative embodiments, instead of using the electrically conductive adhesive materials 118, 120, 122 and 124 to bond the battery 102, the domed lid 104 and/or the substrate 108 together, one or more metallurgical bonding processes may be used to bond these components to form the integrated lidded electronic package 100. Nonlimiting examples of metallurgical bonding processes that can be used include soldering, welding and sintering.

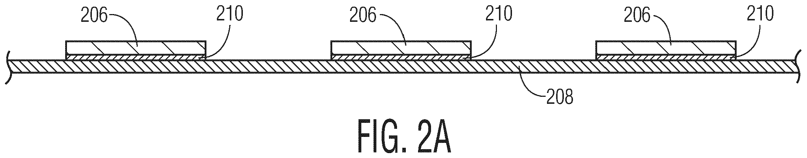

In one or more embodiments, the integrated lidded electronic package 100 may be produced in batches. Figs. 2A-2H illustrate a process of producing a batch of integrated lidded electronic packages in accordance with an embodiment of the invention.

The process begins by attaching a number of dies 206 to a substrate 208 using a bonding material 210, as illustrated in Fig. 2A. The dies can be any type of dies with integrated circuits fabricated on semiconductor material. The substrate can be any substrate with electrical traces or connections, such as a printed circuit board. The bonding material used to attach the dies to the substrate may be, for example, epoxy, eutectic material or solder.

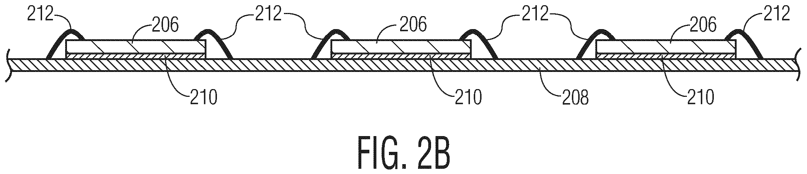

Next, the dies 206 are wire bonded to the substrate 208 using wires 212 to electrically connect the dies to the particular electrical traces or connections on the substrate, as illustrated in Fig. 2B. The electrical traces or connections on the substrate will be electrically connected to batteries.

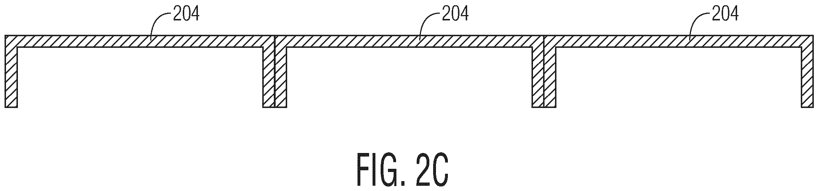

Next, domed lids 204 are provided in strip form, as illustrated in Fig. 2C. The domed lids in strip form may be fabricated using a known process, such as a molding process.

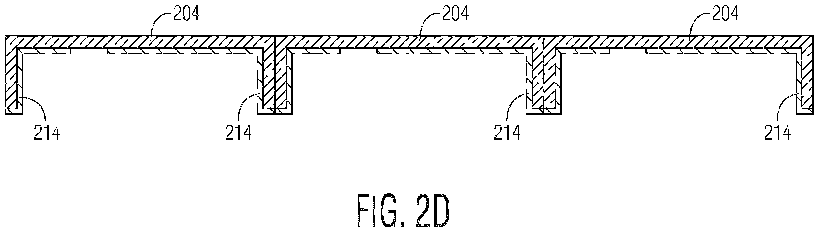

Next, the inner surfaces of the domed lids 204 in the strip form are plated using a conductive material, creating a plating on the inner surfaces of the domed lids. The plating on the inner surfaces of the domed lids is then patterned to produce isolated conductive traces 114, as illustrated in Fig. 2D. The patterning of the plating to produce the isolated conductive traces may be achieved by selectively etching the plating on the inner surfaces of the domed lids.

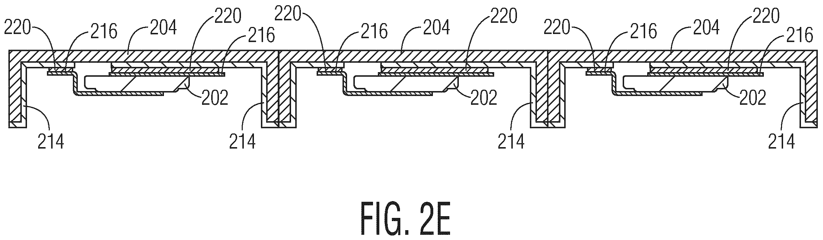

Next, batteries 202 with leads 216 are physically attached to the domed lids 204 using an electrically conductive adhesive material 220 such that the leads are electrically connected to the appropriate conductive traces 214 on the inner surfaces of the domed lids 204, as illustrated in Fig. 2E. As an example, ECA may be used to physically attach the batteries 202 with the leads 216 to the domed lids 204 and to electrically connect the leads to the appropriate conductive traces 214 on the inner surfaces of the domed lids.

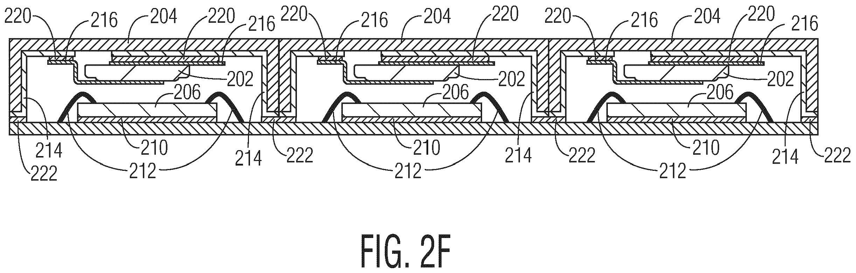

Next, the domed lids 204 in the strip form with the attached batteries 202 are physically attached to the substrate 208 with the attached dies 206 using an electrically conductive adhesive material 222 such that the conductive traces 214 on the inner surface of the domed lid are electrically connected to the appropriate bondwires 212 via the conductive connections on the substrate, as illustrated in Fig. 2F. As an example, ECA may be used to physically attach the domed lids 204 in the strip form to the substrate 208 and to electrically connect the conductive traces 214 on the inner surface of the domed lid to the appropriate bondwires 212 via the conductive connections on the substrate.

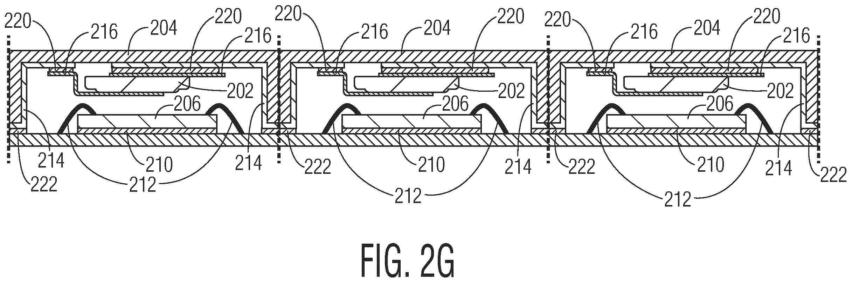

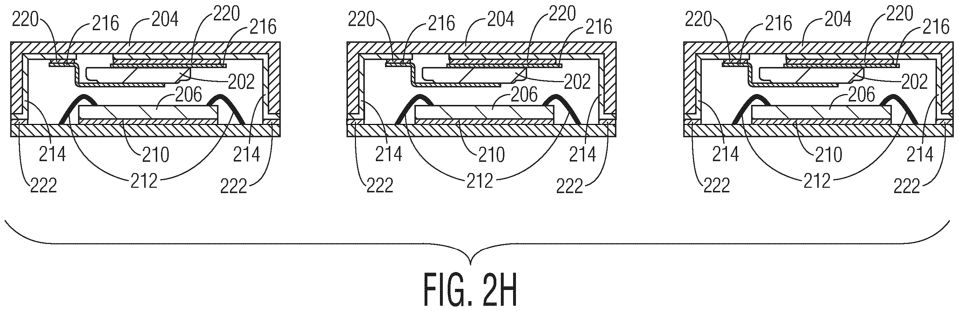

Next, the resulting structure with the domed lids 204 in the strip form attached the substrate 208 is then cut to separate the integrated lidded electronic packages, as illustrated in Fig. 2G, which shows dotted lines where the cuts are made in the structure. The structure may be cut using a mechanical singulation machine or a laser singulation machine. This singulation step results in the individual integrated lidded electronic packages, which are identical to the integrated lidded electronic package 100 of Fig. 1, as illustrated in Fig. 2H.

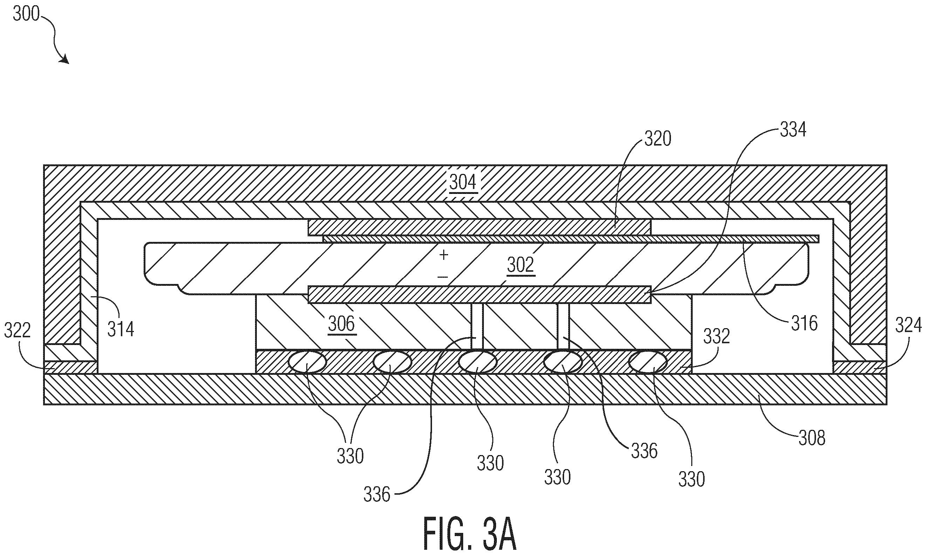

Fig. 3A depicts an integrated lidded electronic package 300 with a battery 302 in accordance with a second embodiment of the invention. The integrated lidded electronic package 300 is similar to the integrated lidded electronic package 100 of Fig. 1. Thus, same or similar reference numbers may be used to identify common elements between the two embodiments. The main difference between the two integrated lidded electronic packages is that the integrated lidded electronic package 300 includes a die 306 without bondwires, e.g., a die that has been attached to a substrate 308 using flip chip technology or a die with surface mount connections, rather the die 106 that has been wire bonded to the substrate 108. Thus, for purposes of illustration, the die 306 may be referred to as the flip chip die 306. The flip chip die 306 is physically and electrically connected to the substrate using solder balls 330. The interface between the flip chip die 306 and the substrate 308 is then filled using an electrically insulating adhesive material 332, such as epoxy.

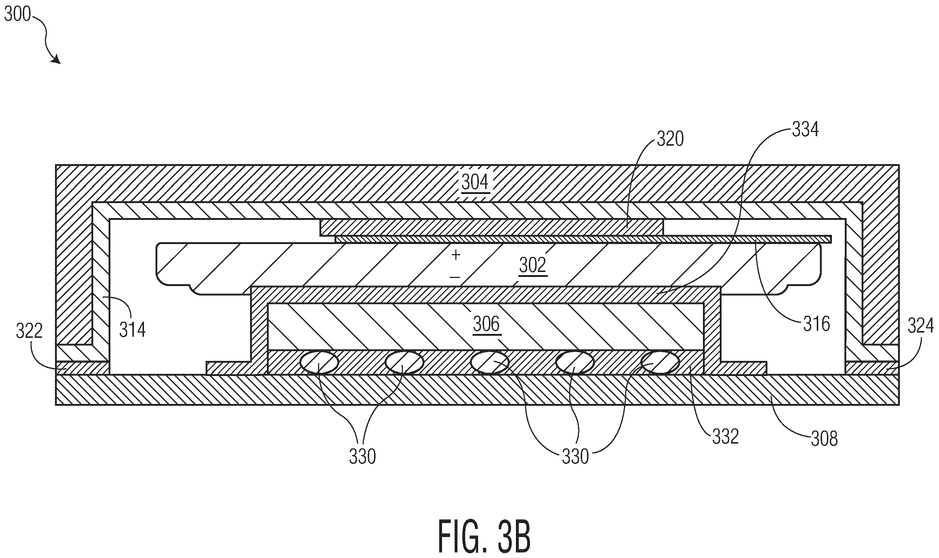

In this embodiment, the battery 302 is physically attached to the flip chip die 306 using an electrically conductive adhesive material 334, e.g., ECA, so that the flip chip die is sandwiched between the battery and the substrate 308. The electrically conductive adhesive material 334 provides an electrical connection between the negative side of the battery 302 to the flip chip die 306. In the illustrated embodiment, the negative side of the battery 302 is connected to the solder balls 330 using through-silicon vias (TSVs) 336. However, in an alternative embodiment, the electrically conductive adhesive material 334 is applied to extend to one or more sides of the flip chip die 306 to contact one or more electrical connections on the substrate 308, as illustrated in Fig. 3B.

For the embodiments illustrated in Figs. 3A and 3B, the integrated lidded electronic package 300 uses a domed lid 304 with a single conductive trace 314 that provide an electrical connection between the positive side of the battery 302 to the substrate 308 via a lead 316, which is attached to the conductive trace 314 using an electrically conductive adhesive material 320. In one or more alternative embodiments, the lead 316 is omitted from the integrated lidded electronic package 300, and the battery 302 is mounted directly to the domed lid 304. The conductive trace 314 may be formed using a plating on the inner surface of the domed lid 304, which does not have to be patterned. The domed lid 304 with the conductive trace 314 is physically and electrically connected to the substrate 308 using electrically conductive adhesive materials 322 and 324, which may be ECA.

Similar to the integrated lidded electronic package 100, in one or more alternative embodiments, instead of using the electrically conductive adhesive materials 320, 322, 324 and 334 to bond the battery 102, the domed lid 104, the flip chip die 306 and/or the substrate 108 together, one or more metallurgical bonding processes may be used to bond these components to form the integrated lidded electronic package 300.

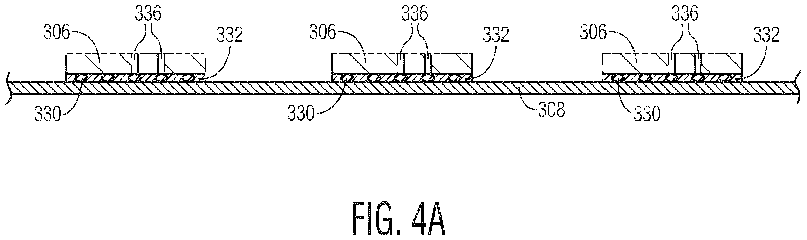

In one or more embodiments, the integrated lidded electronic package 300 of Fig. 3A may be produced in batches. Figs. 4A-4G illustrate a process of producing a batch of integrated lidded electronic packages in accordance with an embodiment of the invention.

The process begins by attaching a number of flip chip dies 306 with TSVs 336 to a substrate 308 using a flip chip method, which includes melting solder balls 330 on the flip chip die and underfilling the interfaces between the flip chip dies and the substrate with an electrically insulating adhesive material 332, as illustrated in Fig. 4A. The electrically insulating adhesive material 332 may be any suitable adhesive made with insulating material, such as epoxy as one nonlimiting example.

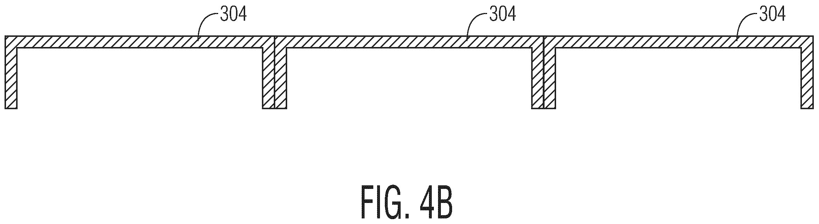

Next, domed lids 304 are provided in strip form, as illustrated in Fig. 4B. The domed lids 304 in the strip form may be fabricated using a known process, such as a molding process.

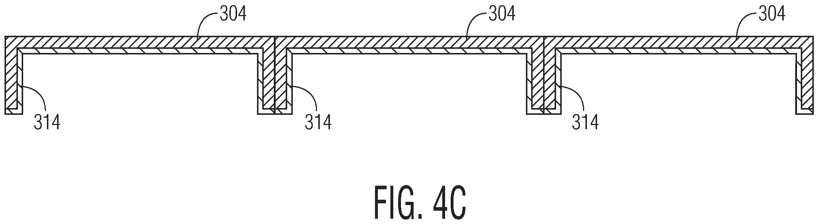

Next, the inner surfaces of the domed lids 304 in the strip form are plated using a conductive material, creating a plating 314 on the inner surfaces of the domed lids, as illustrated in Fig. 4C. The plating 314 will be used as a single conductive trace for each of the domed lids 304.

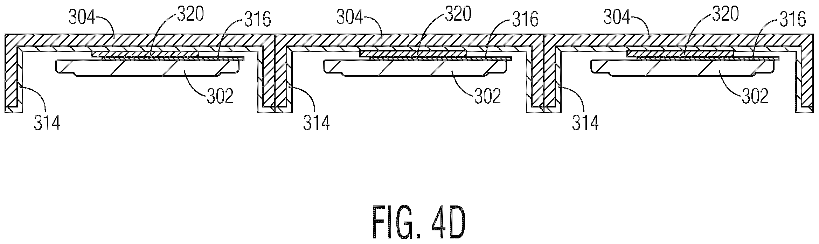

Next, batteries 302 with leads 316 are physically attached to the domed lids 304 using an electrically conductive adhesive material 320 such that the leads are electrically connected to the plating 314 on the inner surfaces of the domed lids, as illustrated in Fig. 4D. As an example, ECA may be used to physically attach the batteries 302 with the leads 316 to the domed lids 304 and to electrically connect the leads 316 to the plating 314 on the inner surfaces of the domed lids. In one or more alternative embodiments, the batteries 302 without the leads 316 are physically attached to the domed lids 304 using the electrically conductive adhesive material 320.

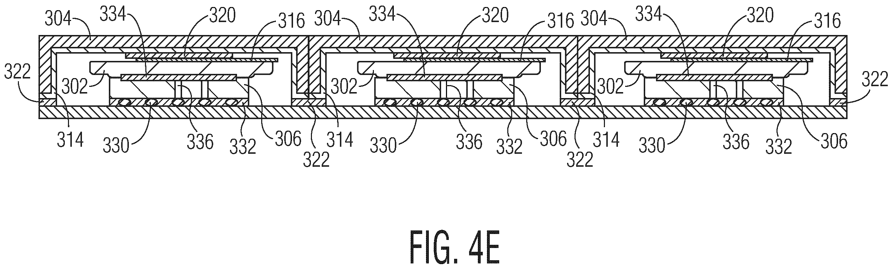

Next, the domed lids 304 in the strip form with the attached batteries 302 are physically attached to the substrate 308 with the flip chip dies 306 using an electrically conductive adhesive material 322 on the substrate. In addition, the batteries 302 are physically attached to the flip chip dies 306 using an electrically conductive adhesive material 334, as illustrated in Fig. 4E. In this embodiment, the electrically conductive adhesive material 334 is only applied to the top surfaces of the flip chip dies 306 to contact through-silicon vias (TSVs) 336, as shown in Fig. 4E, to produce integrated lidded electronic packages corresponding to the integrated lidded electronic package of Fig. 3A.

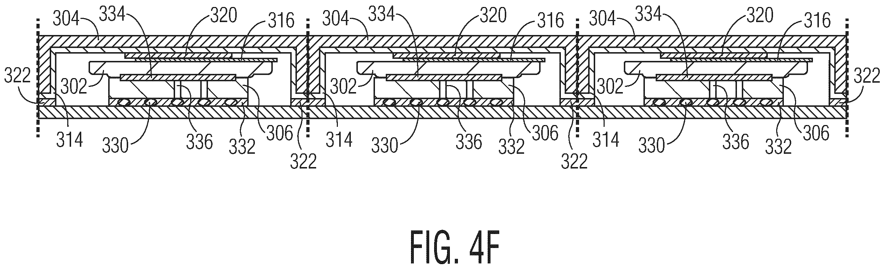

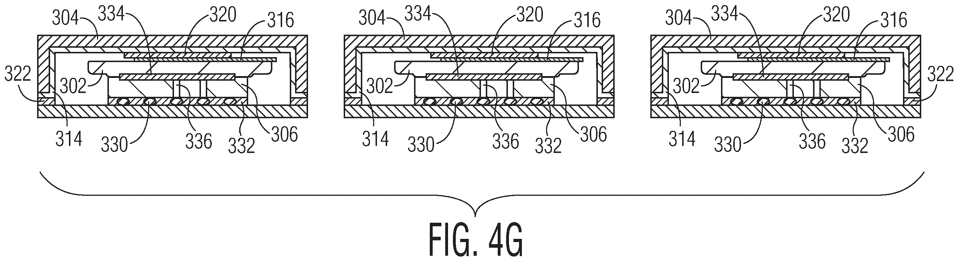

Next, the resulting structure with the domed lids 304 in the strip form attached the substrate 308 is then cut to separate the integrated lidded electronic packages, as illustrated in Fig. 4F, which shows dotted lines where the cuts are made in the structure. The structure may be cut using a mechanical singulation machine or a laser singulation machine. This singulation step results in the individual integrated lidded electronic packages, which are identical to the integrated lidded electronic package 300 of Fig. 3A, as illustrated in Fig. 4G.

The integrated lidded electronic packages corresponding to the integrated lidded electronic package 300 of Fig. 3B can be produced in a similar manner as the integrated lidded electronic packages corresponding to the integrated lidded electronic package 300 of Fig. 3A. However, instead of applying the electrically conductive adhesive material 334 to only the top surfaces of the flip chip dies 306, as shown in Fig. 4E, the electrically conductive adhesive material 334 is applied to the flip chip dies 306 to extend to one or more sides of the flip chip dies from the top surfaces of the flip chip dies, as well as partially on the substrate 308. The resulting structure with the domed lids 304 in the strip form attached the substrate 308 is then cut to separate the integrated lidded electronic packages to produce electronic packages that are identical to the integrated lidded electronic package 300 of Fig. 3B.

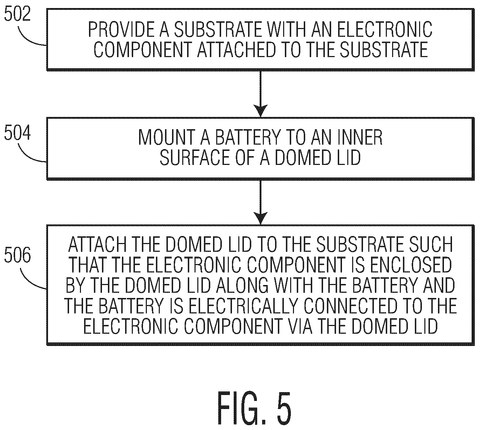

A method for producing an electronic package, such as the integrated lidded electronic packages 100 and 300, in accordance with an embodiment of the invention is described with reference to a flow diagram of Fig. 5. At block 502, a substrate with an electronic component attached to the substrate is provided. At block 504, a battery is mounted to an inner surface of a domed lid. At block 506, the domed lid is attached to the substrate such that the electronic component is enclosed by the domed lid along with the battery and the battery is electrically connected to the electronic component via the domed lid.

Although the step(s) of the method(s) herein are shown and described in a particular order, the order of the steps of each method may be altered so that certain steps may be performed in an inverse order or so that certain steps may be performed, at least in part, concurrently with other steps.

Although specific embodiments of the invention have been described and illustrated, the invention is not to be limited to the specific forms or arrangements of parts so described and illustrated.

## Claims

1. An electronic package comprising:
a substrate;
an electronic component attached to the substrate;
a domed lid attached to the substrate such that the electronic component is enclosed by the domed lid; and
a battery attached to an inner surface of the domed lid and electrically connected to the electronic component via the domed lid.

2. The electronic package of claim 1, wherein the battery includes positive and negative sides and wherein at least one of the positive and negative sides of the battery is electrically connected to an electrical trace on the inner surface of the domed lid that is electrically connected to the electronic component via the substrate.

3. The electronic package of claim 1 or 2, wherein the electronic component is a die physically attached to the substrate and electrically attached to the substrate via bondwires and wherein positive and negative sides of the battery are electrically connected to conductive traces on the inner surface of the domed lid that are electrically connected to the die via the substrate and the bondwires.

4. The electronic package of any preceding claim, further comprising epoxy that covers the bondwires.

5. The electronic package of any preceding claim, wherein the electronic component is a die attached to the substrate and wherein at least one of positive and negative sides of the battery is electrically connected to an electrical trace on the inner surface of the domed lid that is electrically connected to the die via the substrate.

6. The electronic package of claim 5, wherein one of the positive and negative sides of the battery is physically attached to the die using an electrically conductive adhesive material such that the die is sandwiched between the battery and the substrate.

7. The electronic package of claim 6, wherein the electrically conductive adhesive material is electrically connected to at least one electrically conductive via in the die to electrically connect the battery to the substrate.

8. The electronic package of claim 6 or 7, wherein the electrically conductive adhesive material extends to a side of the die and onto the substrate to electrically connect the battery to the substrate.

9. The electronic package of any preceding claim, wherein the domed lid is a pre-molded electrically insulating structure.

10. The electronic package of any preceding claim, wherein the domed lid is attached to the substrate using an electrically conductive adhesive material that provides electrical connection between the domed lid and the substrate.

11. The electronic package of claim 10, wherein the domed lid includes an electrical trace on the inner surface of the domed lid that is electrically connected to the battery and the electrically conductive adhesive material.

12. The electronic package of any preceding claim, wherein the electronic component is a die, a multi-die component, a stacked die or a surface mounted device (SMD) component.

13. A method for producing an electronic package, the method comprising:
providing a substrate with an electronic component attached to the substrate;
mounting a battery to an inner surface of a domed lid; and
attaching the domed lid to the substrate such that the electronic component is enclosed by the domed lid along with the battery and the battery is electrically connected to the electronic component via the domed lid.

14. The method of claim 13, wherein the battery includes positive and negative sides and wherein mounting the battery includes electrically connecting at least one of the positive and negative sides of the battery to an electrical trace on the inner surface of the domed lid so that the battery is electrically connected to the electronic component via the substrate when the domed lid is attached to the substrate.

15. The method of claim 13 or 14, wherein the electronic component is a die physically attached to the substrate and electrically attached to the substrate via bondwires and wherein mounting the battery includes electrically connecting positive and negative sides of the battery to conductive traces on the inner surface of the domed lid so that the positive and negative sides of the battery are electrically connected to the die via the substrate and the bondwires when the domed lid is attached to the substrate.
